(19) **Europäisches Patentamt / European Patent Office / Office européen des brevets**

(11) **EP 3 041 324 B1**

(12) **EUROPEAN PATENT SPECIFICATION**

(45) Date of publication and mention
of the grant of the patent:
**13.05.2020 Bulletin 2020/20**

(21) Application number: **14839536.1**

(22) Date of filing: **29.08.2014**

(51) Int Cl.:
*H05H 1/30* (2006.01)  *C23C 16/511* (2006.01)
*C23C 16/513* (2006.01)  *H01L 21/3065* (2006.01)
*H05H 1/34* (2006.01)  *H05H 1/46* (2006.01)
*C23C 16/455* (2006.01)  *H01J 37/32* (2006.01)

(86) International application number:
**PCT/JP2014/072779**

(87) International publication number:
**WO 2015/030191 (05.03.2015 Gazette 2015/09)**

(54) **MICROWAVE PLASMA PROCESSING DEVICE**

VORRICHTUNG ZUR MIKROWELLENPLASMAVERARBEITUNG

DISPOSITIF DE TRAITEMENT À PLASMA À MICRO-ONDES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.08.2013 JP 2013179286**

(43) Date of publication of application:
**06.07.2016 Bulletin 2016/27**

(73) Proprietor: **National Institute of Advanced
Industrial Science
and Technology
Tokyo 100-8921 (JP)**

(72) Inventors:
• **KIM Jaeho**
  **Tsukuba-shi**
  **Ibaraki 305-8568 (JP)**
• **SAKAKITA Hajime**
  **Tsukuba-shi**
  **Ibaraki 305-8568 (JP)**

(74) Representative: **Graf von Stosch, Andreas et al
Graf von Stosch
Patentanwaltsgesellschaft mbH
Prinzregentenstraße 22
80538 München (DE)**

(56) References cited:
**DE-A1- 19 851 628      JP-A- 2000 096 247
JP-A- 2006 107 829      JP-A- 2007 250 444
JP-A- 2007 299 720      JP-A- 2007 299 720
JP-A- 2008 282 784**

• **KIM JAEHO ET AL: "Microwave-excited
atmospheric-pressure plasma jets using a
microstrip line", APPLIED PHYSICS LETTERS, A
I P PUBLISHING LLC, US, vol. 93, no. 19, 13
November 2008 (2008-11-13), pages
191505-191505, XP012112272, ISSN: 0003-6951,
DOI: 10.1063/1.3025841**

## Description

Technical Field

The present invention relates to a microwave plasma processing device configured to generate plasma with microwave power and to perform processing, such as plasma CVD (chemical vapor deposition), plasma etching, plasma ashing (resist ashing), and plasma nitriding, on substrates to be processed such as wafers.

Background Art

In recent years, plasma processing techniques are indispensable in many fields such as material development and industrial technologies. Plasma is widely used for low-temperature dry process techniques since it can generate high-density radicals while having high non-thermal equilibrium.

A plasma jet is also conventionally used as one of the plasma sources under the pressure between intermediate pressure (1 Torr to 100 Torr) and atmospheric pressure. The plasma jet, which is blown from the nozzle of the device, is useful for performing processing, such as plasma CVD (chemical vapor deposition), plasma etching, plasma ashing (resist ashing), and plasma nitriding, on substrates to be processed such as wafers.

Today, for generating the plasma jet, a method involving DC arc discharge or DC pulse discharge is known well. However, the method involving DC arc discharge or DC pulse discharge has various problems, such as susceptibility to electrode deterioration, and inability to use reactive gas.

A method involving dielectric barrier discharge is also known well. However, the method involving dielectric barrier discharge has various problems, such as occurrence of filamentous discharge, and inability to generate high-density radicals.

An electrodeless plasma jet generator is also known. For example, an inductive coupling-type heat plasma generator using high frequency in a VHF band (30 to 300 MHz) has been proposed (see PTL 1). However, the proposed plasma jet generator have problems such as complicated impedance matching, difficulty in upsizing due to structural obstacles, and various manufacturing and operational limitations attributed to use of a high-voltage electric circuit.

Meanwhile, generation of a plasma jet through microwave discharge provides following advantages:

(1) Inexpensive microwave power source;
(2) Electrodeless operation can be performed to provide a long dischargeable life;
(3) Impedance matching can be performed with a simple element;
(4) Microwave and plasma can efficiently be coupled;
(5) Power can be concentrated on a necessary point since radiation loss to the outside is small; and
(6) Stable high-density plasma can be generated in a wide pressure range including atmospheric pressure.

However, in the conventional plasma generator using microwave power, a microwave transmission line is a waveguide made of a metal tube. This causes problems such as increase in size and cost of the structure of a microwave transmission circuit and difficulty in low-power operation.

Recently, a method for manufacturing a plasma jet generator including a microstrip line, which is a low-power microwave transmission line, in place of the conventional waveguide has been proposed (see PTL 2, PTL 3 and NPL 1). In contrast, the microwave plasma processing device of the present invention advantageously allows the generation of a plasma jet that is stably wide under intermediate and high pressure.

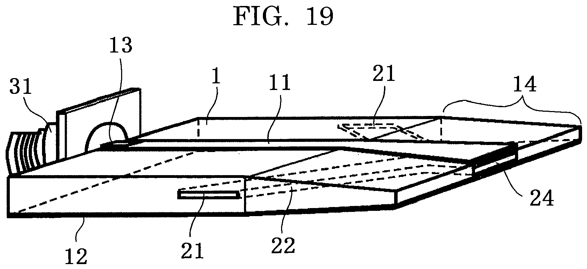

FIG. 19 is a schematic view of a conventional plasma jet generator using a microstrip line. The generator includes a microwave input portion 31, a dielectric substrate 1 having a tapered structure in one end portion and a gas flow channel inside the substrate, a microstrip line 11 for microwave power transmission, and a ground conductor 12 that covers one surface of the dielectric substrate.

Gas, which is input from two gas input ports 21, passes through the gas flow channels 22 and converges in a tapered portion 14 between the microstrip line 11 and the ground conductor 12, and is blown out of the dielectric substrate 1 from a 10-mm-wide nozzle 24.

In the conventional device, the gas input ports 21 are respectively provided on both side surfaces of the dielectric substrate 1, and gas is supplied through the slanting gas flow channels 22 so as to create a gas flow having a uniform flow velocity for the 10-mm-wide nozzle 24.

The microwave (2.45 GHz) power, which is introduced into the dielectric substrate 1 through a coaxial microwave connection 31, propagates between the microstrip line 11 and the ground conductors 12, and concentrates in the nozzle 24. As a consequence, plasma is generated and is blown out of the dielectric substrate 1 from the nozzle 24 together with the gas flow.

Meanwhile, in order to enhance productivity in the plasma process, there is a strong demand for development of a wide-width plasma jet which is capable of performing plasma processing on a large area. Since the plasma generator using a microstrip line can structurally be upsized by arraying the microstrip lines, the possibilities of the generator are promising.

Citation List

Patent Literature

PTL 1: Japanese Patent Application Laid-Open (JP-A) No. 2003-109795
PTL 2: JP-A No. 2007-299720
PTL 3: DE 19851638 A1

Non Patent Literature

NPL 1: Jaeho Kim and et. al., "Microwave-excited atmospheric-pressure plasma jets using a microstrip line", Applied Physics Letters, Vol. 93, 191505 (2008).

Summary of Invention

Technical Problem

However, the conventional low-temperature process using plasma, which is performed under low pressure (0.01 Torr to 1 Torr), is industrially disadvantageous since an expensive high vacuum device is necessary. Accordingly, not only the device is costly, but also the processing takes time, which results in increase in product cost. As a result, there has been a demand for a method for generating non-thermal equilibrium plasma under higher pressure that is intermediate pressure (1 Torr to 100 Torr), or under high pressure (100 Torr to 760 Torr).

In the past, a specific technique for upsizing the plasma jet, such as a method for supplying a uniform gas flow to a wide-width nozzle, was not yet developed, and therefore it was difficult to provide a wide-width plasma jet.

In view of the above-stated circumstance, it is an object of the present invention to provide a microwave plasma processing device capable of stably generating a low-temperature wide-width plasma jet not only under low pressure but also under higher pressure in the range from intermediate pressure to atmospheric pressure.

Solution to Problem

A microwave plasma processing device of the present invention includes: a dielectric substrate; a tapered portion provided in one end portion of the dielectric substrate, the tapered portion being shaped so that a thickness of the dielectric substrate becomes gradually smaller; a microstrip line provided over from one end portion to the other end portion of a first surface, the first surface being one of a front surface and a back surface of the dielectric substrate; a ground conductor provided over from one end portion to the other end portion of a second surface, the second surface being opposite to the first surface of the dielectric substrate; a microwave input portion configured to input a microwave between the microstrip line and the ground conductor in one end portion of the dielectric substrate; a gas input port configured to input gas into a plasma generating portion that is a space configured to generate plasma with the microwave input from the microwave input portion, the space being provided inside the dielectric substrate in the tapered portion; a nozzle configured to discharge the plasma generated with the gas and the microwave supplied to the plasma generating portion; a gas flow widening portion configured to supply a wide-width gas flow having a uniform flow velocity to the plasma generating portion, the gas flow widening portion being formed to make a gas flow width wider as the gas flow advances; and a gas flow channel configured to supply the gas input from the gas input port to the gas flow widening portion.

According to some embodiments of the invention, the gas input port may preferably be configured to input gas into the dielectric substrate. The gas flow widening portion may be provided in the dielectric substrate. In particular, in these embodiments the gas input port (21), the gas flow channel (22), the gas flow widening portion (23), the plasma generating portion (2) and the nozzle (24) may be provided in the dielectric substrate (1).

According to alternative embodiments of the present invention, the microwave plasma processing device further includes a microwave concentration gap that is a space placed between an end of the ground conductor and an end of the microstrip line in the taper portion, the microwave concentration gap being formed on the second surface of the dielectric substrate; a gas supply plate provided in contact with the ground conductor for supplying a wide-width gas flow having a uniform flow velocity to the microwave concentration gap, the gas supply plate containing a gas flow widening portion formed to make a gas flow width wider as the gas flow advances; a gas input port configured to input gas into the gas supply plate; a gas flow channel configured to supply the gas input from the gas input port to the gas flow widening portion in the gas supply plate; a plasma generating portion that is a space configured to generate plasma from the gas supplied from the gas flow widening portion by the microwave radiated through the microwave concentration gap, the space being formed in the gas supply plate and facing the microwave concentration gap; and a nozzle configured to discharge the plasma generated from the gas supplied to the plasma generating portion by the microwave.

In particular, in these alternative embodiments the gas input port (21), the gas flow channel (22), the gas flow widening portion (23), the plasma generating portion (2), and the nozzle (24) may be provided outside the dielectric substrate (1).

Furthermore, the microwave plasma processing device of the present invention according to any of the embodiments described above may be further characterized as follows.

In the microwave plasma processing device of the present invention, the gas flow widening portion includes a gas shower portion that is a portion formed with a plurality of protruding obstacles or pillars provided along a longitudinal direction of the nozzle at fixed intervals.

Furthermore, in the microwave plasma processing device of the present invention, the microstrip line includes: one input terminal provided in one end portion; a branch portion configured to branch the microwave input from the input terminal; a plurality of lines branched from the branch portion; and a plurality of output terminals provided in the other end portion, the plurality of output terminals corresponding to the plurality of lines, wherein the other end portion has a width gradually narrowed to enhance impedance so as to intensify a microwave electric field in the plasma generating portion.

In the microwave plasma processing device of the present invention, the gas flow widening portion includes: one input terminal provided in one end portion; a branch portion configured to branch the gas flow input from the gas flow channel; a plurality of lines each branched from the branch portion and formed to have a width gradually increased to make a width of the gas flow wider as the gas flow advances; and a longitudinally-shaped space wherein the gas flows coming from the plurality of lines converge.

Furthermore, in the microwave plasma processing device of the present invention, the dielectric substrates and the ground conductors are shared and arranged side by side to generate plasma long in a longitudinal direction.

Furthermore, in the microwave plasma processing device of the present invention, rare gas, reactive gas, or mixed gas of the rare gas and the reactive gas is supplied to generate plasma under low pressure, intermediate pressure, or high pressure.

Advantageous Effects of Invention

According to the present invention, it becomes possible to stably generate and maintain a wide-width plasma jet not only under low pressure but also under intermediate pressure and high pressure. As a result, the present invention can implement material processing, such as large-area surface reforming, etching, ashing, cleaning, oxidizing/nitriding, and CVD (Chemical Vapor Deposition) film formation using a wide-width microwave excitation plasma jet, under atmospheric pressure (or low pressure or intermediate pressure).

Brief Description of Drawings

FIG. 1 is a perspective view of a plasma processing device representing one example of a first embodiment of the present invention.
FIG. 2 is a perpendicular cross sectional view of the plasma processing device illustrated in FIG. 1.
FIG. 3 is a horizontal cross sectional view of the plasma processing device illustrated in FIG. 1.
FIG. 4 is a block diagram of a microstrip line of the present invention.

FIG. 5 is a schematic view of the plasma processing device representing one example of the first embodiment of the present invention.
FIG. 6 is a schematic view of the plasma processing device representing one example of the first embodiment in the present invention.
FIG. 7 illustrates a velocity distribution of the gas flow in the plasma processing device illustrated in FIG. 3.
FIG. 8 illustrates a velocity distribution of the gas flow in a longitudinal direction of the nozzle 24 in the plasma processing device illustrated in FIG. 3.
FIG. 9 is a horizontal cross sectional view in the plasma processing device representing one example of a second embodiment of the present invention.
FIG. 10 illustrates a velocity distribution of the gas flow in the plasma processing device illustrated in FIG. 9.
FIG. 11 is a photograph of a wide-width plasma jet generated in the atmospheric pressure air by the plasma processing device representing the example of the second embodiment of the present invention.
FIG. 12 illustrates an emission spectrum of light emitted from a plasma jet generated in the atmospheric pressure air by the plasma processing device representing the example of the second embodiment of the present invention.
FIG. 13 is a photograph of a wide-width nitrogen plasma jet generated by the plasma processing device representing the example of the second embodiment of the present invention.
FIG. 14 illustrates minimum microwave power required for igniting and maintaining the plasma jet generated by the plasma processing device representing the example of the second embodiment in the present invention.
FIG. 15 is a schematic view of a plasma processing device representing one example of a third embodiment of the present invention.
FIG. 16 is a perpendicular cross sectional view of the plasma processing device illustrated in FIG. 15.
FIG. 17 is a horizontal cross sectional view of the plasma processing device illustrated in FIG. 15.
FIG. 18 is a plasma processing device of the third embodiment of the present invention.
FIG. 19 is an explanatory perspective view of a conventional plasma generator with a microstrip line.

Description of Embodiments

<First embodiment>

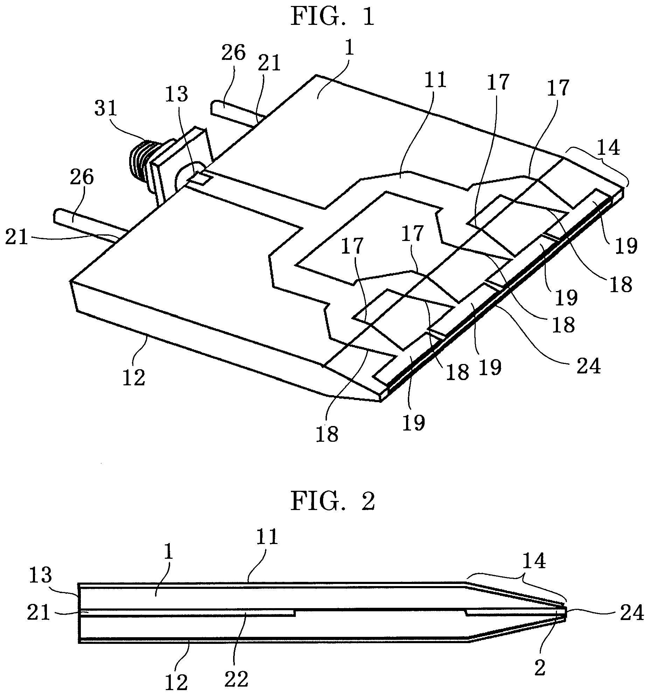

FIGS. 1, 2, and 3 illustrate the configuration of a plasma processing device representing one example of a first embodiment in the present invention. FIGS. 1 to 3 are a perspective view, a perpendicular cross sectional view, and a horizontal cross sectional view of the plasma processing device, respectively.

The plasma processing device of the present embodiment includes a dielectric substrate 1, a microwave input portion 13, a microstrip line 11, a ground conductor 12, a tapered portion 14, a gas input port 21, a gas flow channel 22, a gas flow widening portion 23, a plasma generating portion 2, and a nozzle 24.

The dielectric substrate 1 is preferably made of a material small in dielectric loss of a microwave and high in heat conductivity. For example, the dielectric substrate 1 is made of an appropriate material, such as alumina, quartz, and sapphire. The dielectric substrate 1 may also be made of an appropriate bendable (flexible) material, such as polystyrol-based materials and polystyrene-based materials. A dielectric constant and a thickness of the dielectric substrate 1 influence the characteristic impedance of a microwave propagation circuit. The dielectric substrate 1 may appropriately be selected in consideration of microwave propagation characteristics, the shape of the plasma processing device, the heat characteristic of the plasma processing device, and the like. The dielectric substrate 1 may be made by one substrate, or may be a laminate of a plurality of substrates. The dielectric substrate 1 may also be a laminate of a plurality of substrates different in material from each other.

The microwave input portion 13 is configured to excite a microwave between the microstrip line 11 and the ground conductor 12 in one end portion of the dielectric substrate 1. For example, the microwave input portion 13 may be an SMA connection, an SMB connection, an N connection, a BNC connection, and an OSM connection for microwave coaxial cables, or the like.

The microwave input portion 13 may also be constructed by making a hole in the ground conductor 12 and attaching a microwave connection thereto.

The microstrip line 11 is provided over from one end portion to the other end portion of a first surface of the dielectric substrate 1. Although a word "microstrip" is used herein as one example, other conductors may appropriately be used as long as they propagate a microwave.

The shape of the microstrip line 11 is an important factor that determines characteristics, such as an impedance and an electric field distribution of the microwave circuit, and a distribution ratio of microwave power. In order to achieve generation of uniform plasma jets, it is necessary to optimize the shape of the microstrip line 11. In designing the microwave circuit for the microstrip line 11, techniques to implement uniform distribution of microwave power, matching of characteristic impedance, matching of impedance, and the like have already been established as wireless communication techniques, and therefore these techniques may appropriately be used.

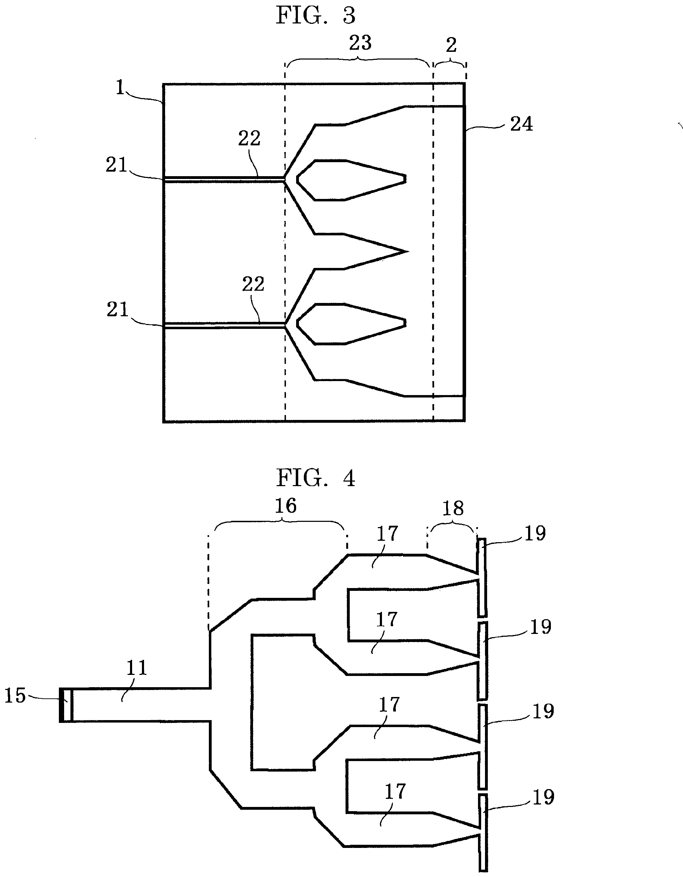

FIG. 4 is a block diagram of the microstrip line 11 as one example of the present invention. The microstrip line 11 includes one input terminal 15 in one end portion, a branch portion 16 for branching the microwave input from the input terminal, a plurality of lines 17 branched from the branch portion 16, and a plurality of output terminals 19 in a terminal 18 on the other output side, the output terminals 19 corresponding to the plurality of lines 17.

In the plasma processing device in the example of the present invention illustrated in FIG. 1, the microwave transmission line is branched two times from one microwave input portion 13 to form four lines 17, so that microwave power can uniformly be supplied to the 50-mm width plasma generating portion 2.

As illustrated in FIG. 4, the output-side end portions 18 and the output terminals 19 of the microstrip line 11 can be made into an appropriate shape so that space distribution of the microwave electric field in the plasma generating portion 2 (refer to FIG. 3) is uniform and that the electric field strength is large.

In this embodiment, as illustrated in FIG. 1, the end portions 18 of the microstrip line 11 are shaped to have their width gradually narrowed and are connected with their corresponding output terminals 19 having a longitudinal shape. As the width of the microstrip line 11 is narrower, the characteristic impedance of the microwave propagation circuit is higher. As the characteristic impedance is higher, the voltage applied to the microstrip line 11 and the ground conductor 12 by fixed microwave power increases. As a result, the electric field of the microwave between the microstrip line 11 and the ground conductor 12 becomes larger as defined in the following mathematical formula 1:

[Mathematical Formula 1]

$$E = V / d$$

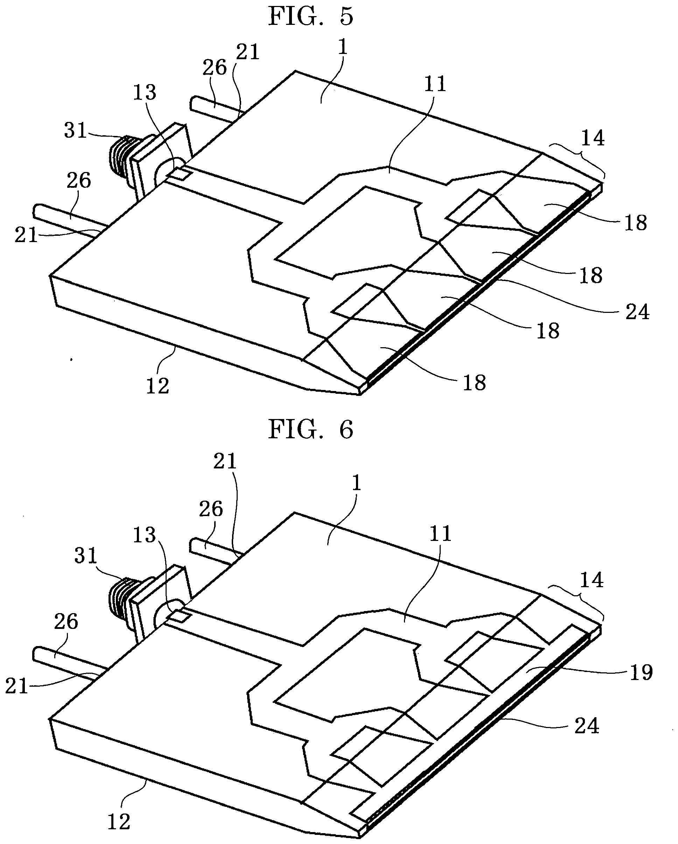

In this mathematical formula, E is an electric field, and V and d are a voltage and a distance between the microstrip line 11 and the ground conductor 12, respectively. As illustrated in FIG. 5, the end portion of the microstrip line 11 may be shaped so that the width of the end portions 18 on the output side of the microstrip line 11 gradually increases.

Or the output terminals 19 in the microstrip line 11 may independently be provided corresponding to a plurality of branched lines 17, or the plurality of output terminals 19 may be integrated as illustrated in FIG. 6.

As illustrated in FIGS. 1 and 2, the ground conductor 12 is provided over from one end portion to the other end portion of a second surface which is opposite to the first surface (the surface having the microstrip line 11 formed thereon) of the dielectric substrate 1. The ground conductor 12 may be constituted by a conductor that covers the entire second surface of the dielectric substrate 1, or may be constituted by a conductor formed on part of the second surface.

The microstrip line 11 and the ground conductor 12 may be made of an appropriate conductor material, such as copper, gold, silver, aluminum, or nickel. The microstrip line 11 and the ground conductor 12 may be made on the dielectric substrate 1 by using general IC manufacturing techniques, such as metal deposition or etching. Or the microstrip line 11 and the ground conductor 12 may be formed by applying an appropriate conductor plate on the front surface of the dielectric substrate 1 with adhesives.

The tapered portion 14 is provided by shaping the dielectric substrate 1 so that a thickness becomes gradually smaller in one end portion of the dielectric substrate 1. The tapered portion 14 may be shaped so that the inclination of a slope of the first surface is identical to the inclination of a slope of the second surface in the dielectric substrate 1, or may be shaped so that only one of the first surface and the second surface of the dielectric substrate 1 has a slope.

The electric field of the microwave between the microstrip line 11 and the ground conductor 12 is stronger as the thickness of the dielectric substrate 1 is smaller, i.e., a distance between the microstrip line 11 and the ground conductor 12 is shorter (see Expression 1). Based on this principle, the microwave electric field is intensified in the tapered portion 14.

The tapered portion 14 may be provided to have a length equal to a quarter-wavelength of a standing microwave formed in the dielectric substrate. Or the tapered portion 14 may have an appropriate length in consideration of an inclination angle of the shape of the tapered portion 14, characteristic impedance, and the like. By setting appropriate inclination angle and length of the tapered portion 14, it becomes possible to considerably suppress a reflected microwave reflected from plasma.

The gas input port 21 and the gas flow channel 22 are provided to supply gas to the gas flow widening portion 23 (FIG. 3). The appropriate number and shape of the gas input ports 21 and the gas flow channels 22 may be determined in consideration of the shape, size, and the like of the plasma processing device.

The gas input port 21 may be provided in one end portion of the dielectric substrate 1, and may also be provided in other surfaces of the dielectric substrate 1. A gas pipe 26 and a gas connection connected with the gas input port 21 are preferably made of an insulating material, but they may also be made of metal. To use the gas pipe 26 and the gas connection made of metal, they need to be provided at appropriate positions in consideration of the influence on microwave propagation.

The gas flow widening portion 23 (FIG. 3) is provided to uniformly widen the gas supplied from the gas flow channel 22 and to supply the gas to the plasma generating portion 2. The gas flow widening portion 23 includes: one input terminal in one end portion; a branch portion configured to branch a gas flow input from the gas flow channel 22; a plurality of lines each branched from the branch portion and formed to have a width gradually increased to make a width of the gas flow wider; and a longitudinally-shaped space wherein the gas flows coming from the plurality of lines converge. When the gas input from the gas input port passes through the gas flow widening portion 23, the gas is widened into a longitudinal shape at a uniform flow velocity.

FIG. 3 illustrates an example relating to the gas flow widening portion 23 of the present invention. In this example, gas is input from two gas input ports 21 into each of the gas flow channels 22. The flows of the input gas are each branched into two flows in the gas flow widening portion 23. The width of the gas flows gradually widened in the gas flow widening portion 23. Then, four branched gas flows converge in the plasma generating portion 2. As a consequence, a uniform gas flow widened to a width of 50 mm can be supplied to the plasma generating portion 2.

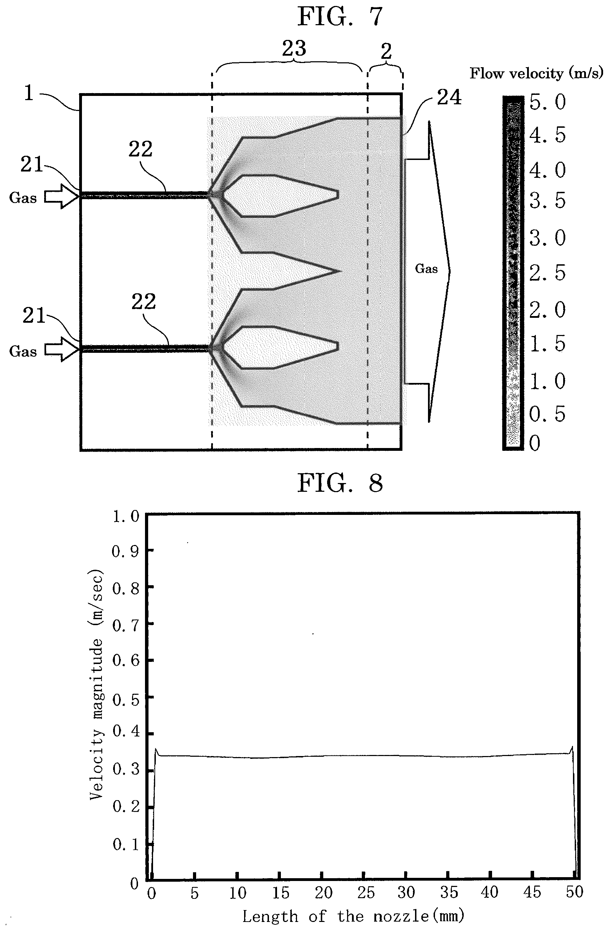

FIG. 7 illustrates the result of simulating a velocity distribution of the gas flow in the gas flow widening portion 23 in the example illustrated in FIG. 3. The simulation is performed under the following conditions. That is, a gas type is nitrogen; a total flow rate of gas input into two gas input ports 21 is 300 sccm; surrounding pressure is atmospheric pressure (760 Torr); the gas input port 21 has a cross section of 1 mm in width; the plasma generating portion 2 and the nozzle 24 have a long width of 50 mm; and the gas input port 21, the gas flow widening portion 23, the plasma generating portion 2, and the nozzle 24 have a height of 0.5 mm.

The gas input into the gas flow widening portion 23 through the gas input port 21 and the gas flow channel 22 is widened to a width of 50 mm at a uniform flow velocity while the gas passes through the gas flow widening portion 23. The gas is then passes through the plasma generating portion 2 and is blown to the outside from the nozzle 24.

The flow velocity of the gas input into the gas flow widening portion 23 from the gas flow channel 22 was about 12.0 m/sec. The flow velocity of the gas in the nozzle 24 ranged from 0.33 m/sec to 0.35 m/sec in the longitudinal direction of the nozzle 24, indicating a uniform flow velocity distribution. FIG. 8 illustrates a distribution of the gas flow velocity along the major axis of the nozzle 24.

As the flow velocity of the gas input into the gas flow widening portion 23 from the gas flow channel 22 is further increased, the uniformity of the gas flow velocity in the nozzle 24 deteriorates. The flow velocity of the gas input into the gas flow widening portion 23 from the gas flow channel 22 is largely dependent on the flow rate of the gas input into the gas input port 21, the cross section of the gas flow channel 22, pressure outside the nozzle 24, and the like.

If an appropriately-shaped gas flow widening portion 23 is provided corresponding to a maximum flow velocity of the gas input into the gas flow widening portion 23, that is, if a longer gas flow widening portion 23 is provided for example, a uniform wide-width gas flow can be supplied to the plasma generating portion 2 and the nozzle 24.

The plasma generating portion 2 (FIG. 3) is a space where the gas supplied from the gas flow widening portion 23 is plasmatized by the microwave electric field. The plasma generating portion 2 is preferably provided as one space so that wide-width plasma is uniformly generated. The space of the plasma generating portion 2 may be constituted of a plurality of spaces in consideration of application of the plasma processing device.

The nozzle 24 is a port for blowing off the plasma generated in the plasma generating portion 2 together with the gas to the outside of the dielectric substrate 1. It is preferable to provide one nozzle 24 so that wide-width plasma is uniformly blown off. The nozzle 24 can appropriately be shaped corresponding to the cross sectional shape of a desired plasma jet.

<Principle of plasma generation>

The microwave introduced from the microwave input portion 13 into the dielectric substrate 1 between the microstrip line 11 and the ground conductor 12 propagates along the microstrip line 11 and is branched off. The electric field of the microwave is gradually intensified in the tapered portion 14 where the distance between the microstrip line 11 and the ground conductor 12 is narrow, and takes a maximum value between the end of the microstrip line 11 and the end of the ground conductor 12. The concentrated electric field of the microwave excites the gas supplied to the plasma generating portion, resulting in generation of plasma. The generated plasma is blown from the nozzle 24 together with the gas flow. As a result, a wide-width uniform plasma jet can be supplied.

<Second embodiment>

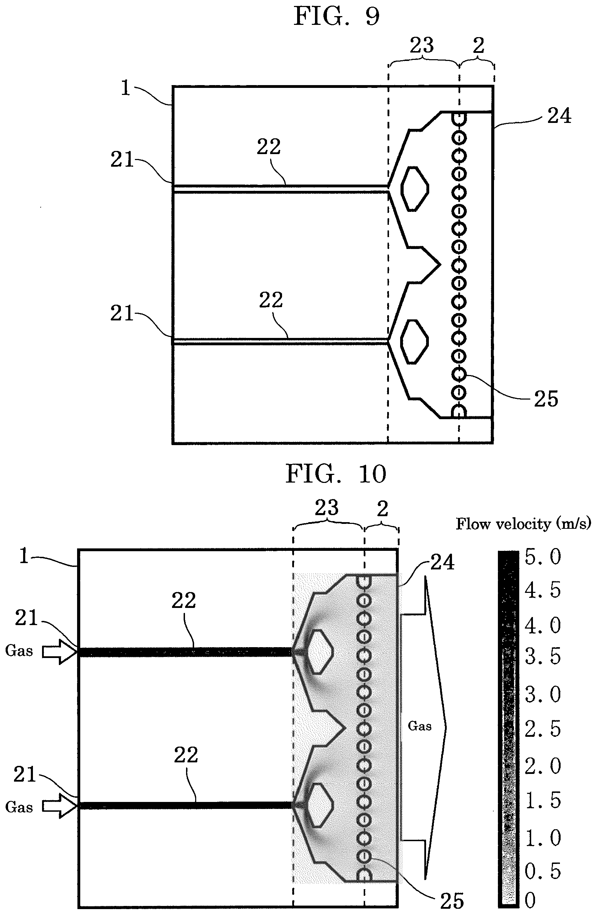

A plasma processing device representing a second embodiment of the present invention is based on the plasma processing device in the first embodiment in which a gas shower portion 25 for uniformly widening a gas flow is provided in the gas flow widening portion 23 as illustrated in FIG. 9.

If an overlapping region of the gas flow widening portion 23 and the microstrip line 11 is wide, an influence of the microwave propagation circuit on the characteristic impedance increases and the plasma generating region 2 tends to protrude to the region of the gas flow widening portion 23. As a solution to this problem, the gas flow channel 22 may be lengthened and the gas flow widening portion 23 may be shortened.

When the gas flow widening portion 23 is shortened, it becomes difficult to uniformly widen the gas flow having a high flow velocity. Accordingly, providing the gas shower portion 25 makes it possible to uniformly widen the gas flow having the high flow velocity.

The gas shower portion 25 is provided by forming a plurality of protruding obstacles along a major axis direction of the nozzle 24 at fixed intervals. The gas shower portion 25 can also be provided by forming a plurality of pillars at fixed intervals.

The protruding obstacles and the pillars in the gas shower portion 25 may separately be provided, or may be formed by processing the dielectric substrate 1. The protruding obstacles and the pillars may have cross sections in circle, triangle and square shapes, or the like.

The intervals and the cross sections of the protruding obstacles and the pillars may appropriately be determined in consideration of a mean free path of gaseous particles (an average value of flight distances of gaseous particles from collision with other gaseous particles to collision with next gaseous particles).

FIG. 9 is a horizontal cross sectional view of the plasma processing device of the second embodiment of the present invention. The gas shower portion 25 provided in the plasma processing device of the second embodiment is provided by processing the dielectric substrate 1 so that a plurality of circular pillars 2 mm in diameter are formed at intervals of 3 mm (with a distance from the center of a pillar to the center of the next pillar being 3 mm).

FIG. 10 illustrates the result of simulating a velocity distribution of the gas flow in the plasma processing device of the second embodiment illustrated in FIG. 9. The simulation is performed under the following conditions. That is, a gas type is nitrogen; a total flow rate of gas input into two gas input ports 21 is 400 seem; surrounding pressure is atmospheric pressure (760 Torr); the gas input port 21 has a cross section of 1 mm in width; the plasma generating portion 2 and the nozzle 24 have a long width of 50 mm; and the gas input port 21, the gas flow widening portion 23, the plasma generating portion 2, and the nozzle 24 have a height of 0.5 mm. The circular pillars in the gas shower portion are 2 mm in diameter, and intervals between the pillars are 3 mm.

The flow velocity of the gas input from the gas flow channel 22 into the gas flow widening portion 23 was about 18.0 m/sec. The flow velocity of the gas in the nozzle 24 ranged from 0.44 m/sec to 0.50 m/sec in the longitudinal direction of the nozzle 24, indicating a uniform flow velocity distribution.

The gas flowing into the gas flow widening portion 23 through the gas input port 21 and the gas flow channel 22 is widened to a width of 50 mm at a uniform flow velocity while the gas passes through the gas flow widening portion 23. The gas then passes through the plasma generating portion 2 and is blown to the outside from the nozzle 24.

The plasma processing device in the present invention can provide a wide-width plasma jet stably generated and maintained not only under low pressure but also under intermediate pressure and high pressure.

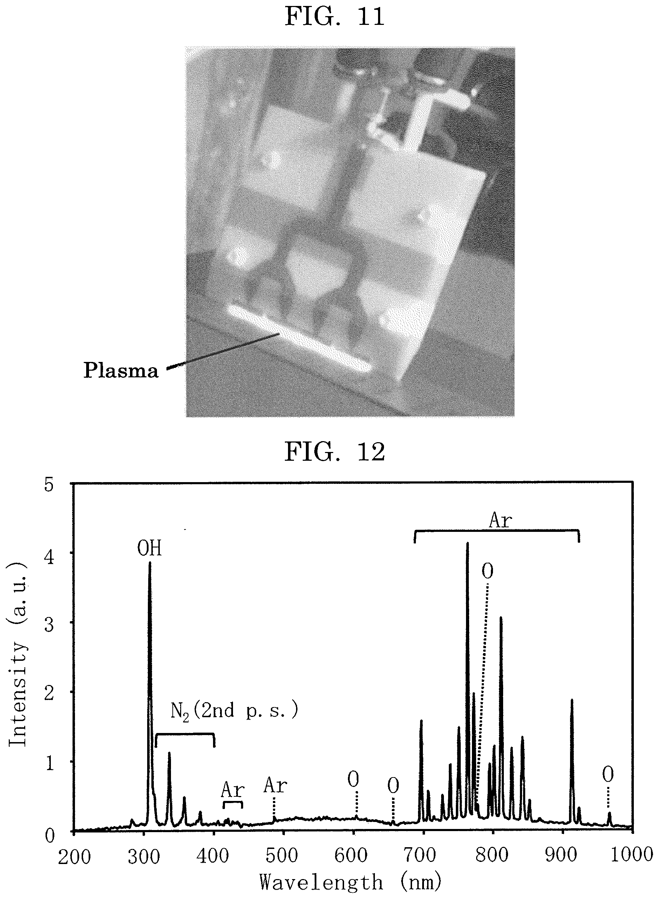

A description is now given of an experiment of generating a wide-width plasma jet. FIG. 11 is a photograph of a wide-width plasma jet generated in the atmospheric pressure air by the plasma processing device in the second embodiment of the present invention.

Under the atmospheric pressure, argon (Ar) gas is used as operating gas in order to stably generate and maintain plasma. A wide-width plasma 50 mm in width is stably blown off in the atmospheric pressure. Plasma generation is performed under the conditions that a flow rate of Ar gas is 0.1 L/mim to 10 L/mim, a microwave frequency is 2.45 GHz, and microwave power is 30 W to 100 W. Instead of Ar gas, rare gas such as helium (He) or neon (Ne) may also be used as operating gas.

With this wide-width plasma jet, various plasma processings can be performed in the atmospheric pressure. For example, surface reforming (enhancement in hydrophilicity, adhesion, and the like) of a substrate to be processed can be performed by blowing Ar gas plasma jet to the front surface of the substrate to be processed that is put in the air.

When the Ar gas plasma jet is blown off, it catches and plasmatizes surrounding air (containing $N_2$, $O_2$, $H_2O$, $CO_2$, and the like). As a result, chemical reaction species (radicals), such as oxygen-based species and nitrogen-based species, are generated.

FIG. 12 illustrates an emission spectrum obtained from an Ar gas plasma jet blown into the atmospheric pressure air. In addition to the emission spectrum of Ar, optical spectra of radicals, such as excited species of OH, O, and $N_2$ are plotted. Among these radicals, the OH radical in particular is one of the important radicals in plasma processings such as surface reforming. As illustrated in FIG. 12, a peak of the emission spectrum of an OH radical in the vicinity of a wavelength 309 cm$^{-1}$ is 3.4 times higher than a highest peak (in the vicinity of 337 cm$^{-1}$) in the 2nd positive system of $N_2$ molecules. This indicates that OH radicals are generated with density higher than that of other radicals. In the case of a widely-used atmospheric pressure plasma jet (using Ar gas or He gas as operating gas) involving dielectric barrier discharge, the peak of the emission spectrum of the OH radicals is lower than that of $N_2$ molecules.

This is a characteristic of the plasma processing device of the present invention, which can be obtained because the plasma processing device of the present invention has a capability of stably generating high-density plasma by efficiently concentrating microwave power in a plasma generation space in the plasma generating portion using the microstrip line.

Surfaces of a polycarbonate substrate, a polyimide film, a glass substrate, a print sheet, and the like were processed in the atmospheric air by using the Ar gas plasma jet of the present embodiment, which brought about excellent experimental results such as super hydrophilicity. A plasma ashing experiment for detaching a resist in the atmospheric air was also conducted by using the Ar gas plasma jet of the present embodiment. As a result, it was confirmed that low-temperature and high-speed processing could be performed.

The plasma processing device of the present invention can be operated by using a small amount of reactive gas mixed into Ar gas as operating gas. For example, in the aforementioned surface reforming and ashing treatment, processing time is shortened by supplying Ar gas with a small amount of oxygen or air mixed therein.

In the plasma processing device of the present invention, Ar gas with a small amount of methane ($CH_4$) gas, hydrogen ($H_2$) gas, and the like mixed therein at an appropriate ratio may be supplied as operating gas. As a result, it becomes possible to apply the present invention to atmospheric pressure plasma CVD for synthesis of carbon materials, such as diamond like carbon (DLC) thin films, nanocrystal diamond thin films, and graphene films. The plasma processing device of the present invention can perform consecutive processing of the materials to be processed by providing a movable substrate stage under the wide-width plasma jet.

The plasma processing device of the present invention can generate reactant gas plasma without using rare gas, such as Ar gas and He gas, as operating gas under low pressure and intermediate pressure. In order to improve the stability and uniformity of plasma or to reduce operation power, rare gas such as Ar gas and He gas can also be used as operating gas.

An experiment of generating plasma was conducted by using the plasma processing device of the present invention under the intermediate pressure. The plasma processing device representing the second embodiment of the present invention was installed in a vacuum housing, and microwave power and gas were supplied to the plasma processing device through a flange. As gas, only $N_2$ gas was used and the above-stated operating gas was not used. The gas pressure in the vacuum housing was controlled by controlling an exhaust valve of the vacuum housing with the flow rate of $N_2$ gas being fixed at 500 sccm.

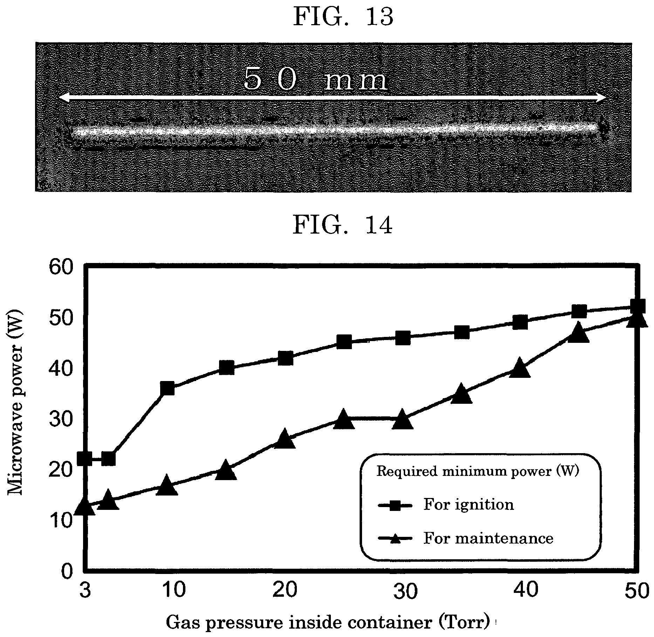

Plasma was self-ignited and maintained. FIG. 13 is a photograph of a wide-width plasma jet generated with 10 Torr. The photograph was taken from the front side of the plasma jet. As is clear from plasma emission in the photograph, uniform wide-width plasma was generated.

FIG. 14 illustrates the result of examining minimum microwave power required for ignition of plasma and maintenance of plasma and the pressure (3 Torr to 50 Torr) inside the container. When the pressure inside the vacuum housing was 3 Torr, plasma was ignited with microwave power of 22 W, and was maintained until power was 13 W. The minimum power required for plasma ignition and plasma maintenance was higher as the pressure inside the housing increased. When the pressure inside the vacuum housing was 50 Torr, plasma was ignited with the microwave power of 52 W and was maintained until power was 50 W.

As these examples indicate, the plasma processing device of the present invention can generate stable nitrogen plasma with low electric power. The nitrogen plasma is expected to be applied to plasma nitriding processes, such as nitriding treatment of the surface of metal such as copper and manufacturing of nitride semiconductors.

<Third embodiment>

A plasma processing device representing a third embodiment of the present invention is configured so that the gas input port 21, the gas flow channel 22, the gas flow widening portion 23, the plasma generating portion 2, and the nozzle 24 provided inside the dielectric substrate 1 of the plasma processing device of the first embodiment are provided outside the dielectric substrate 1. The gas input port 21, the gas flow channel 22, the gas flow widening portion 23, the plasma generating portion 2, and the nozzle 24 are provided in a gas supply plate 27 which is provided in contact with the ground conductor 12.

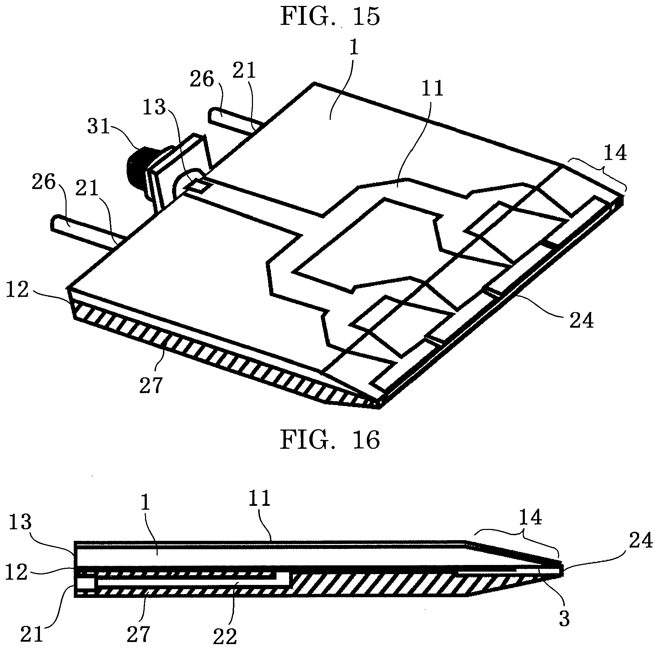

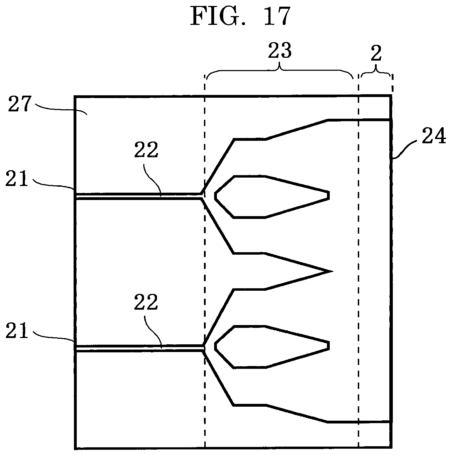

FIGS. 15, 16, and 17 are block diagrams of the plasma processing device representing the third embodiment of the present invention. FIGS. 15 and 16 are a perspective view and a perpendicular cross sectional view of the plasma processing device, respectively. FIG. 17 is a horizontal cross sectional view of the gas supply plate 27.

In the present embodiment, the tapered portion 14 in the dielectric substrate 1 is shaped to have a slope only on the first surface of the dielectric substrate 1. The tapered portion 14 may be shaped so that the inclination of a slope of the first surface is identical to the inclination of a slope of the second surface in the dielectric substrate 1, or may be shaped so that only one of the first surface and the second surface of the dielectric substrate 1 has a slope. In this case, it is necessary to appropriately match the shapes of the ground conductor 12 and the gas supply plate 27 with the shape of the dielectric substrate 1.

The microstrip line 11 and the ground conductor 12 are each provided over from one end portion to the other end portion of a first surface and a second surface of the dielectric substrate 1, the second surface being opposite to the first surface. A microwave concentration gap 3 is formed on a portion of the front surface of the dielectric substrate 1 placed between an end of the ground conductor and an end of the microstrip line.

The electric field of a microwave which has propagated along a dielectric between the microstrip line 11 and the ground conductor 12 becomes strongest in the microwave concentration gap 3 and is strongly emitted to the outside of the dielectric substrate 1. Plasma is generated and maintained by this strong microwave electric field. A width of the microwave concentration gap 3, i.e., a distance between the end of the microstrip line 11 and the ground conductor 12, is an important factor determined by the electric field strength of the microwave and the microwave discharge characteristic. It is necessary to appropriately adjust the width of the microwave concentration gap 3 in accordance with operation characteristics of the plasma processing device.

The width of the microwave concentration gap 3 can easily be controlled by, for example, changing the distance between the end of the ground conductor 12 and the end of the dielectric substrate 1 while fixing the microstrip line 11. The gas supply plate 27 is provided in contact with the ground conductor 12. The gas supply plate 27 may be made of a metal material same as the material of the ground conductor, may be made of a metal material different from the material of the ground conductor 12, or may be made of a dielectric material. For example, appropriate materials, such as alumina and quartz, can also be used. The gas supply plate 27 is equipped with the gas input port 21, the gas flow channel 22, the gas flow widening portion 23, the plasma generating portion 2, and the nozzle 24 of the plasma processing device representing the first embodiment of the present invention.

In the present embodiment, the gas flow widening portion 23 used in the plasma processing device representing the first embodiment or the second embodiment of the present invention can be used. The gas supply plate 27 has the gas input port 21 and the gas flow channel 22 configured and positioned appropriately for supplying gas to the gas flow widening portion 23. One surface of the plasma generating portion 2 provided in the gas supply plate 27 is entirely or partially opened, so that the microwave concentration gap 3 is arranged therein. The nozzle 24 is formed by the end of the gas supply plate 27 and the end of the dielectric substrate 1 as illustrated in FIG. 17.

<Fourth embodiment>

A plasma processing device representing a fourth embodiment of the present invention is based on the plasma processing device in the third embodiment, in which a gas shower portion 25 for uniformly widening a gas flow is provided in the gas flow widening portion 23. Providing the gas shower portion 25 makes it possible to uniformly widening a gas flow of a higher flow velocity.

<Upsizing plasma jet by arraying>

A plasma jet can be upsized by applying an arraying technique to the first to fourth embodiments of the present invention.

The plasma processing device in the first embodiment of the present invention can be upsized by appropriately providing a plurality of microstrip lines 11, one ground conductor 12, a plurality of gas input ports 21, a plurality of gas flow channels 22, a plurality of gas flow widening portions 23, one longitudinal plasma generating portion, and one longitudinal nozzle in one longitudinal dielectric substrate 1 having the tapered portion 14.

The second embodiment of the present invention can be upsized by appropriately providing the gas shower portion 25 along the longitudinal nozzle 24 in the upsized plasma processing device representing the first embodiment.

The plasma processing device representing the third embodiment of the present invention can be upsized by providing a plurality of microstrip line 11 and one ground conductor 12 in one longitudinal dielectric substrate 1 having the tapered portion 14 and appropriately providing a plurality of gas input ports 21, a plurality of gas flow channels 22, a plurality of gas flow widening portions 23, one longitudinal plasma generating portion, and one longitudinal nozzle in one longitudinal gas supply plate 27.

The fourth embodiment of the present invention can be upsized by appropriately providing the gas shower portion 25 along the longitudinal nozzle 24 in the upsized plasma processing device representing the second embodiment.

To upsize the device, the microstrip line 11, the gas flow channel 22, and the gas flow widening portion 23 may be branched into plurality instead of being arrayed.

If the upsizing technique of the present invention is applied, a microwave electric field having a uniform distribution and a gas flow having a uniform flow velocity along the longitudinal direction can be supplied to the longitudinal plasma generating portion 2 and the longitudinal nozzle 24, which makes it possible to provide the plasma processing device which generates a uniform wide-width plasma jet.

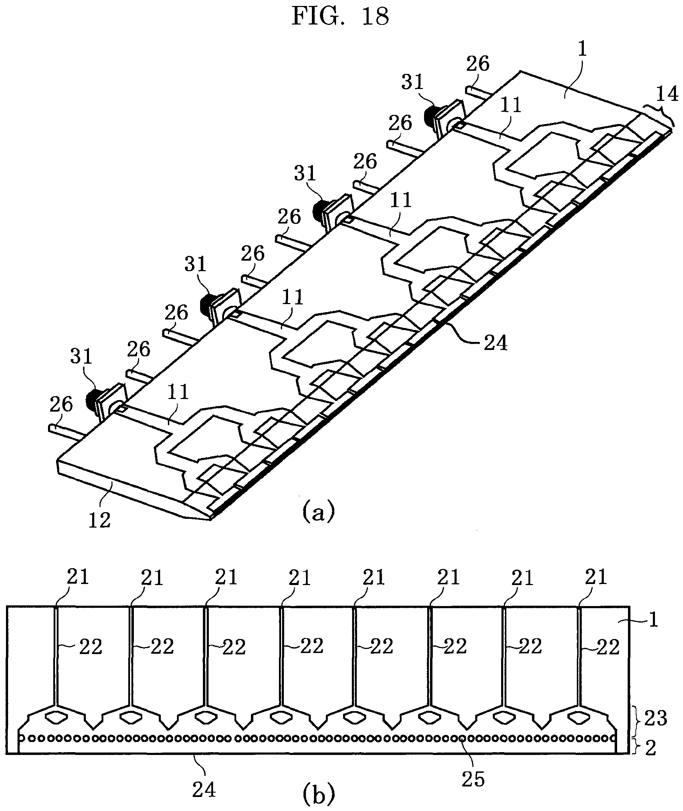

FIG. 18(a) and FIG. 18(b) illustrate another embodiment of the present invention. FIG. 18(a) and FIG. 18(b) are a perspective view of a plasma jet generator upsized by arraying, and a horizontal cross sectional view of the gas flow widening portion 23, respectively.

In the present embodiment, a wide-width plasma jet having a width of 200 mm can be provided by arraying four plasma processing devices representing the second embodiment of the present invention.

Upsizing can be achieved by providing four microwave input portions 13, four microstrip lines 11, one longitudinal ground conductor 12 (210 mm), eight gas input ports 21, eight gas flow channels 22, four gas flow widening portions 23, one longitudinal plasma generating portion 2 (200 mm), a gas shower portion 25 provided between the gas flow widening portion 23 and the plasma generating portion 2, and one longitudinal nozzle 24 (200 mm) in one longitudinal dielectric substrate 1 (210 mm in width and 6 mm in thickness). This makes it possible to generate and maintain a wide-width plasma jet having a width of 200 mm.

Industrial Applicability

The device of the present invention, which is manufactured and operated at low cost, is capable of providing a low-temperature and wide-width plasma jet not only under low pressure but also under intermediate pressure and high pressure and is also capable of generating high-density radicals. Accordingly, the device can be applied to industrial mass production processes.

The device of the present invention can be used as a large-scale plasma generation system for material surface processes, material synthesis, environmental application, medical application, and the like.

Reference Signs List

| 1  | Dielectric substrate |
|----|----------------------|
| 2  | Plasma generating portion |
| 3  | Microwave concentration gap |
| 11 | Microstrip line |
| 12 | Ground conductor |
| 13 | Microwave induction |
| 14 | Tapered portion |
| 15 | Input terminal of microstrip line |
| 16 | Branch portion of microstrip line |
| 17 | Output-side end portion of microstrip line |
| 18 | Branched lines of microstrip line |
| 19 | Output terminal of microstrip line |
| 21 | Gas input port |
| 22 | Gas flow channel |
| 23 | Gas flow widening portion |
| 24 | Nozzle |
| 25 | Gas shower portion |
| 26 | Gas pipe |
| 27 | Gas supply plate |
| 31 | Microwave connection |

**Claims**

1. A microwave plasma processing device, comprising:

   a dielectric substrate (1);
   a tapered portion (14) provided in one end portion of the dielectric substrate (1), the tapered portion (14) being shaped so that a thickness of the dielectric substrate becomes gradually smaller;
   a microstrip line (11) provided over from one end portion to the other end portion of a first surface, the first surface being one of a front surface and a back surface of the dielectric substrate (1);
   a ground conductor (12) provided over from one end portion to the other end portion of a second surface, the second surface being opposite to the first surface of the dielectric substrate (1);
   a microwave input portion (13) configured to input a microwave between the microstrip line (11) and the ground conductor (12) in one end portion of the dielectric substrate (1);
   a plasma generating portion (2) that is a space configured to generate plasma with the microwave input from the microwave input portion, the space being provided in the tapered portion;
   a gas input port (21) configured to input gas into the plasma generating portion;
   a nozzle (24) configured to discharge the plasma generated with the gas and the microwave supplied to the plasma generating portion (2), **characterized in that** the microwave plasma processing device comprises a gas flow widening portion (23) configured to supply a wide-width gas flow having a uniform flow velocity to the plasma generating portion (2), the gas flow widening portion (23) being formed to make a gas flow width wider as the gas flow advances; and

a gas flow channel (22) configured to supply the gas input from the gas input port (21) to the gas flow widening portion (23).

2. The microwave plasma processing device according to claim 1, wherein the gas input port (21), the gas flow channel (22), the gas flow widening portion (23), the plasma generating portion (2) and the nozzle (24) are provided in the dielectric substrate (1).

3. The microwave plasma processing device according to claim 1, comprising:

   a microwave concentration gap (3) that is a space placed between an end of the ground conductor (12) and an end of the microstrip line (11) in the tapered portion (14), the microwave concentration gap (3) being formed on the second surface of the dielectric substrate (1);
   a gas supply plate (27) provided in contact with the ground conductor (12) for supplying a wide-width gas flow having a uniform flow velocity to the microwave concentration gap (14), the gas supply plate (27) containing a gas flow widening portion formed to make a gas flow width wider as the gas flow advances, wherein
   the gas input port (21) is configured to input gas into the gas supply plate (27);
   the gas flow channel (22) is configured to supply the gas input from the gas input port (21) to the gas flow widening portion in the gas supply plate (27);
   the plasma generating portion (2) is a space configured to generate plasma from the gas supplied from the gas flow widening portion by the microwave radiated through the microwave concentration gap (3), the space being formed in the gas supply plate (27) and facing the microwave concentration gap (3); and
   the nozzle (24) is configured to discharge the plasma generated from the gas supplied to the plasma generating portion (2) by the microwave.

4. The microwave plasma processing device according to claim 3, wherein the gas input port (21), the gas flow channel (22), the gas flow widening portion (23), the plasma generating portion (2), and the nozzle (24) are provided outside the dielectric substrate (1).

5. The microwave plasma processing device according to any one of claims 1 to 4, wherein the gas flow widening portion (23) includes a gas shower portion (25) that is a portion formed with a plurality of protruding obstacles or pillars provided along a longitudinal direction of the nozzle (24) at fixed intervals.

6. The microwave plasma processing device according to any one of claims 1 to 5, wherein the microstrip line (11) includes:

   one input terminal (15) provided in one end portion;
   a branch portion (16) configured to branch the microwave input from the input terminal;
   a plurality of lines (17) branched from the branch portion (16); and
   a plurality of output terminals (19) provided in the other end portion, the plurality of output terminals (19) corresponding to the plurality of lines (17), wherein
   the other end portion has a width gradually narrowed to enhance impedance so as to intensify a microwave electric field in the plasma generating portion (2).

7. The microwave plasma processing device according to any one of claims 1 to 6, wherein the gas flow widening portion (23) includes:

   one input terminal provided in one end portion;
   a branch portion configured to branch the gas flow input from the gas flow channel;
   a plurality of lines each branched from the branch portion and formed to have a width gradually increased to make a width of the gas flow wider as the gas flow advances; and
   a longitudinally-shaped space wherein the gas flows coming from the plurality of lines converge.

8. The microwave plasma processing device according to any one of claims 1 to 7, wherein the dielectric substrates (1) and the ground conductors (12) are shared and arranged side by side to generate plasma long in a longitudinal direction.

9. The microwave plasma processing device according to any one of claims 1 to 8, wherein rare gas, reactive gas, or mixed gas of the rare gas and the reactive gas is supplied to generate plasma under low pressure, intermediate pressure, or high pressure.

**Patentansprüche**

1. Eine Mikrowellen-Plasma-Bearbeitungsvorrichtung, umfassend:

ein dielektrisches Substrat (1);

einen verjüngten Abschnitt (14), der in einem Endabschnitt des dielektrischen Substrats (1) vorgesehen ist, wobei der verjüngte Abschnitt (14) so geformt ist, dass eine Dicke des dielektrischen Substrats zunehmend kleiner wird;

eine Mikrostreifen-Leitung (11), die von einem Endabschnitt zu dem anderen Endabschnitt einer ersten Oberfläche verläuft, wobei die erste Oberfläche eine Vorderfläche oder eine Rückfläche des dielektrischen Substrats (1) ist;

einen Erdungsleiter (12), der von einem Endabschnitt zu dem anderen Endabschnitt einer zweiten Oberfläche verläuft, wobei die zweite Oberfläche der ersten Oberfläche des dielektrischen Substrats (1) gegenüberliegt;

einen Mikrowellen-Eingangsabschnitt (13), der so konfiguriert ist, dass er eine Mikrowelle zwischen der Mikrostreifen-Leitung (11) und dem Erdungsleiter (12) in einem Endabschnitt des dielektrischen Substrats (1) eingibt;

einen Plasmaerzeugungsabschnitt (2), der ein Raum ist, der so konfiguriert ist, dass er Plasma mit dem Mikrowelleneingang vom Mikrowellen-Eingangsabschnitt erzeugt, wobei der Raum im verjüngten Abschnitt vorgesehen ist;

einen Gaseinlassanschluss (21), der so konfiguriert ist, dass er Gas in den Plasmaerzeugungsabschnitt einleitet;

eine Düse (24), die so konfiguriert ist, dass sie das mit dem Gas und der Mikrowelle erzeugte Plasma entlädt, das dem Plasmaerzeugungsabschnitt (2) zugeführt wird,

**dadurch gekennzeichnet, dass** die Mikrowellen-Plasma-Bearbeitungsvorrichtung einen Gasströmungsverbreiterungsabschnitt (23) umfasst, der so konfiguriert ist, dass er einen Gasstrom großer Breite mit einer gleichmäßigen Strömungsgeschwindigkeit dem Plasmaerzeugungsabschnitt (2) zuführt, wobei der Gasströmungsverbreiterungsabschnitt (23) so ausgebildet ist, dass sich eine Gasstrombreite vergrößert, wenn der Gasstrom voranschreitet; und

einen Gasströmungskanal (22), der so konfiguriert ist, dass er den Gaseinlass von dem Gaseinlassanschluss (21) dem Gasströmungsverbreiterungsabschnitt (23) zuführt.

2. Mikrowellen-Plasma-Bearbeitungsvorrichtung nach Anspruch 1, wobei der Gaseinlassanschluss (21), der Gasströmungskanal (22), der Gasströmungserweiterungsabschnitt (23), der Plasmaerzeugungsabschnitt (2) und die Düse (24) in dem dielektrischen Substrat (1) vorgesehen sind.

3. Mikrowellen-Plasma-Bearbeitungsvorrichtung nach Anspruch 1, umfassend:

einen Mikrowellen-Konzentrationsspalt (3), der ein Raum ist, der zwischen einem Ende des Erdungsleiters (12) und einem Ende der Mikrostreifen-Leitung (11) in dem verjüngten Abschnitt (14) angeordnet ist, wobei der Mikrowellen-Konzentrationsspalt (3) auf der zweiten Oberfläche des dielektrischen Substrats (1) ausgebildet ist;

eine Gaszuführungsplatte (27), die in Kontakt mit dem Erdungsleiter (12) vorgesehen ist, um einen Gasstrom großer Breite mit einer gleichmäßigen Strömungsgeschwindigkeit dem Mikrowellen-Konzentrationsspalt (14) zuzuführen, wobei die Gaszuführungsplatte (27) einen Gasströmungsverbreiterungsabschnitt enthält, der so ausgebildet ist, dass er eine Gasstrombreite vergrößert, wenn der Gasstrom voranschreitet, wobei

der Gaseinlassanschluss (21) so konfiguriert ist, dass er Gas in die Gaszuführungsplatte (27) einleitet;

der Gasströmungskanal (22) so konfiguriert ist, dass er den Gaseinlass vom Gaseinlassanschluss (21) dem Gasströmungsverbreiterungsabschnitt in der Gaszuführungsplatte (27) zuführt;

der Plasmaerzeugungsabschnitt (2) ein Raum ist, der so konfiguriert ist, dass er Plasma aus dem Gas erzeugt, das von dem Gasströmungserweiterungsabschnitt von der durch den Mikrowellen-Konzentrationsspalt (3) abgestrahlte Mikrowelle zugeführt wird, wobei der Raum in der Gaszuführungsplatte (27) ausgebildet ist und dem Mikrowellen-Konzentrationsspalt (3) zugewandt ist; und

die Düse (24) so konfiguriert ist, dass sie das Plasma entlädt, das aus dem Gas erzeugt wird, das dem Plasmaerzeugungsabschnitt (2) von der Mikrowelle zugeführt wird.

4. Mikrowellen-Plasma-Bearbeitungsvorrichtung nach Anspruch 3, wobei der Gaseinlassanschluss (21), der Gasströmungskanal (22), der Gasströmungsverbreiterungsabschnitt (23), der Plasmaerzeugungsabschnitt (2) und die Düse (24) außerhalb des dielektrischen Substrats (1) vorgesehen sind.

5. Mikrowellen-Plasma-Bearbeitungsvorrichtung nach einem der Ansprüche 1 bis 4, wobei der Gasströmungsverbreiterungsabschnitt (23) einen Gasduschabschnitt (25) umfasst, der ein Abschnitt ist, der mit einer Vielzahl von vorstehenden Hindernissen oder Säulen gebildet ist, die entlang einer Längsrichtung der Düse (24) in vorgegebenen Abständen vorgesehen sind.

6. Mikrowellen-Plasma-Bearbeitungsvorrichtung nach einem der Ansprüche 1 bis 5, wobei die Mikrostreifen-Leitung (11) enthält:

einen Eingangsanschluss (15), die in einem Endteil vorgesehen ist;

einen Verzweigungsabschnitt (16), der so konfiguriert ist, dass sich der Mikrowelleneingang vom Eingangsanschluss verzweigt;

eine Vielzahl von Leitungen (17), die von dem Verzweigungsabschnitt (16) abzweigen; und

eine Vielzahl von Ausgangsanschlüssen (19), die in dem anderen Endabschnitt vorgesehen sind, wobei die Vielzahl von Ausgangsanschlüssen (19) der Vielzahl von Leitungen (17) entspricht, wobei

der andere Endabschnitt eine zunehmend verjüngte Breite hat, um die Impedanz zu erhöhen, so dass ein elektrisches Mikrowellenfeld im Plasmaerzeugungsabschnitt (2) verstärkt wird.

7. Mikrowellen-Plasma-Bearbeitungsvorrichtung nach einem der Ansprüche 1 bis 6, wobei
der Gasströmungsverbreiterungsabschnitt (23) enthält:

einen Eingangsanschluss, der in einem Endabschnitt vorgesehen ist;

einen Verzweigungsabschnitt, der so konfiguriert ist, dass sich die Gasstromzufuhr vom Gasströmungskanal verzweigt;

eine Vielzahl von Leitungen, die jeweils von dem Verzweigungsabschnitt abzweigen und so ausgebildet sind, dass deren Breite sich zunehmend vergrößert, um die Breite des Gasstroms zu vergrößern, wenn der Gasstrom voranschreitet; und

ein längsförmiger Raum, in dem die von der Vielzahl der Leitungen kommenden Gasströme zusammenlaufen.

8. Mikrowellen-Plasma-Bearbeitungsvorrichtung nach einem der Ansprüche 1 bis 7, wobei
die dielektrischen Substrate (1) und die Erdungsleiter (12) geteilt werden und nebeneinander angeordnet sind, um ein in Längsrichtung langes Plasma zu erzeugen.

9. Mikrowellen-Plasma-Bearbeitungsvorrichtung nach einem der Ansprüche 1 bis 8, bei der Edelgas, reaktives Gas oder Mischgas aus Edelgas und reaktivem Gas zugeführt wird, um Plasma unter niedrigem Druck, mäßigem Druck oder hohem Druck zu erzeugen.

**Revendications**

1. Dispositif de traitement au plasma par micro-onde, comprenant :

un substrat diélectrique (1) ;

une partie effilée (14) prévue dans une partie d'extrémité du substrat diélectrique (1), la partie effilée (14) étant conformée de sorte que l'épaisseur du substrat diélectrique devienne progressivement plus petite ;

une ligne microruban (11) prévue sur une zone allant d'une partie d'extrémité à l'autre partie d'extrémité d'une première surface, la première surface étant l'une d'une surface avant et d'une surface arrière du substrat diélectrique (1) ;

un conducteur de terre (12) prévu sur une zone allant d'une partie d'extrémité à l'autre partie d'extrémité d'une deuxième surface, la deuxième surface étant opposée à la première surface du substrat diélectrique (1) ;

une partie d'entrée de micro-onde (13) configurée pour introduire une micro-onde entre la ligne microruban (11) et le conducteur de terre (12) dans une partie d'extrémité du substrat diélectrique (1) ;

une partie de génération de plasma (2) qui est un espace configuré pour générer un plasma avec la micro-onde introduite à partie de la partie d'entrée de micro-onde, l'espace étant prévu dans la partie effilée ;

un orifice d'entrée de gaz (21) configuré pour introduire un gaz dans la partie de génération de plasma ;

une buse (24) configurée pour décharger le plasma généré avec le gaz et la micro-onde fournis à la partie de génération de plasma (2),
**caractérisé en ce que** le dispositif de traitement au plasma par micro-onde comprend une partie d'élargissement d'écoulement de gaz (23) configurée pour fournir un écoulement de gaz de grande largeur ayant une vitesse d'écoulement uniforme à la partie de génération de plasma (2), la partie d'élargissement d'écoulement de gaz (23) étant formée pour agrandir une largeur d'écoulement de gaz à mesure que l'écoulement de gaz avance ; et

un canal d'écoulement de gaz (22) configuré pour fournir le gaz introduit à partir de l'orifice d'entrée de gaz (21) à la partie d'élargissement d'écoulement de gaz (23).

2. Dispositif de traitement au plasma par micro-onde selon la revendication 1, dans lequel l'orifice d'entrée de gaz (21), le canal d'écoulement de gaz (22), la partie d'élargissement d'écoulement de gaz (23), la partie de génération de plasma (2) et la buse (24) sont prévus dans le substrat diélectrique (1).

3. Dispositif de traitement au plasma par micro-onde selon la revendication 1, comprenant :

un écart de concentration de micro-onde (3) qui est un espace placé entre une extrémité du conducteur de terre (12) et une extrémité de la ligne microruban (11) dans la partie effilée (14), l'écart de concentration de micro-onde (3) étant formé sur la deuxième surface du substrat diélectrique (1) ;

une plaque d'alimentation en gaz (27) mise en contact avec le conducteur de terre (12) pour fournir un écoulement de gaz de grande largeur ayant une vitesse d'écoulement uniforme à l'écart de concentration de micro-onde (14), la plaque d'alimentation en gaz (27) contenant une partie d'élargissement d'écoulement de gaz formée pour agrandir une largeur d'écoulement de gaz à mesure que l'écoulement de gaz avance, où

l'orifice d'entrée de gaz (21) est configuré pour introduire un gaz dans la plaque d'alimentation en gaz (27) ;

le canal d'écoulement de gaz (22) est configuré pour fournir le gaz introduit à partir de l'orifice d'entrée de gaz (21) à la partie d'élargissement d'écoulement de gaz dans la plaque d'alimentation en gaz (27) ;

la partie de génération de plasma (2) est un espace configuré pour générer un plasma à partir du gaz fourni par la partie d'élargissement d'écoulement de gaz par la micro-onde rayonnée à travers l'écart de concentration de micro-onde (3), l'espace étant formé dans la plaque d'alimentation en gaz (27) et faisant face à l'écart de concentration de micro-onde (3) ; et

la buse (24) est configurée pour décharger le plasma généré à partir du gaz fourni à la partie de génération de plasma (2) par la micro-onde.

4. Dispositif de traitement au plasma par micro-onde selon la revendication 3, dans lequel l'orifice d'entrée de gaz (21), le canal d'écoulement de gaz (22), la partie d'élargissement d'écoulement de gaz (23), la partie de génération de plasma (2) et la buse (24) sont prévus à l'extérieur du substrat diélectrique (1).

5. Dispositif de traitement au plasma par micro-onde selon l'une quelconque des revendications 1 à 4, dans lequel la partie d'élargissement d'écoulement de gaz (23) comporte une partie d'aspersion de gaz (25) qui est une partie formée avec une pluralité d'obstacles ou de piliers en saillie prévus le long d'une direction longitudinale de la buse (24) à des intervalles fixes.

6. Dispositif de traitement au plasma par micro-onde selon l'une quelconque des revendications 1 à 5, dans lequel la ligne microruban (11) comporte :

une borne d'entrée (15) prévue dans une partie d'extrémité ;

une partie de ramification (16) configurée pour ramifier la micro-onde introduite à partir de la borne d'entrée ;

une pluralité de lignes (17) ramifiées à partir de la partie de ramification (16) ; et

une pluralité de bornes de sortie (19) prévues dans l'autre partie d'extrémité, la pluralité de bornes de sortie (19) correspondant à la pluralité de lignes (17), dans lequel

l'autre partie d'extrémité a une largeur progressivement rétrécie pour améliorer l'impédance de manière à intensifier un champ électrique de micro-onde dans la partie de génération de plasma (2).

7. Dispositif de traitement au plasma par micro-onde selon l'une quelconque des revendications 1 à 6, dans lequel la partie d'élargissement d'écoulement de gaz (23) comporte :

une borne d'entrée prévue dans une partie d'extrémité ;

une partie de ramification configurée pour ramifier l'écoulement de gaz introduit à partir du canal d'écoulement de gaz ;

une pluralité de lignes chacune ramifiée à partir de la partie de ramification et formée de manière à avoir une largeur progressivement augmentée pour agrandir une largeur de l'écoulement de gaz à mesure que l'écoulement de gaz avance ; et

un espace de forme longitudinale dans lequel les écoulements de gaz provenant de la pluralité de lignes convergent.

8. Dispositif de traitement au plasma par micro-onde selon l'une quelconque des revendications 1 à 7, dans lequel les substrats diélectriques (1) et les conducteurs de terre (12) sont partagés et agencés côte à côte pour générer un plasma le long d'une direction longitudinale.

9. Dispositif de traitement au plasma par micro-onde selon l'une quelconque des revendications 1 à 8, dans lequel un gaz rare, un gaz réactif ou un gaz mixte du gaz rare et du gaz réactif est fourni pour générer un plasma sous basse pression, pression intermédiaire ou haute pression.

FIG. 1

FIG. 2

FIG. 3

FIG. 4

FIG. 5

FIG. 6

## FIG. 7

## FIG. 8

## FIG. 9

## FIG. 10

# FIG. 11

Plasma

# FIG. 12

FIG. 13

FIG. 14

FIG. 15

FIG. 16

FIG. 17

FIG. 18

(a)

(b)

FIG. 19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003109795 A
- JP 2007299720 A
- DE 19851638 A1

**Non-patent literature cited in the description**

- **JAEHO KIM.** Microwave-excited atmospheric-pressure plasma jets using a microstrip line. *Applied Physics Letters,* 2008, vol. 93, 191505